# EUROPÄISCHE PATENTSCHRIFT

(11) **EP 0 685 767 B1**
(45) Veröffentlichungstag und Bekanntmachung des Hinweises auf die Patenterteilung: **16.08.2000**
(21) Anmeldenummer: 95107763.5
(22) Anmeldetag: 22.05.1995
(51) Int. Cl.: G03F 7/32

(54) **Entwickler für Photoresistschichten**
Developer for photoresist layers
Révélateurs de photo réserve

(30) Priorität: 01.06.1994 DE 4419166
(43) Veröffentlichungstag der Anmeldung: 06.12.1995
(73) Patentinhaber: Clariant GmbH, 65929 Frankfurt am Main (DE)
(72) Erfinder: van Werden, Karl, Dr., D-65307 Bad Schwalbach (DE); Eltgen, Marlies, D-65343 Eltville (DE)

(56) Entgegenhaltungen:
- EP-A- 0 178 495
- EP-A- 0 178 496
- EP-A- 0 474 010
- WO-A-94/15262
- GB-A- 2 193 335
- US-A- 4 833 067

## Beschreibung

Die Erfindung betrifft einen metallionenfreien Entwickler, der Wasser und mindestens eine wasserlösliche, organische, basische Verbindung enthält, sowie ein entsprechendes Konzentrat. Der Entwickler ist für bildmäßig bestrahlte, positiv-arbeitende Aufzeichnungsschichten - insbesondere Photoresistschichten - geeignet.

Strahlungsempfindliche Gemische, die bei der Herstellung von Druckplatten, Trockenresists oder Photoresists verwendet werden, enthalten als strahlungsempfindliche Komponente gewöhnlich Naphthochinondiazid-Derivate. Auch die Kombination einer Verbindung, die unter der Einwirkung aktinischer Strahlung Säure hervorbringt, mit einer Verbindung, die durch diese Säure gespalten und damit in dem nachfolgend angewendeten Entwickler löslicher wird, ist möglich. Darüber hinaus enthalten diese Gemische üblicherweise polymere Bindemittel, die phenolische Hydroxylgruppen tragen. Im allgemeinen sind dies Novolake oder Polyhydroxystyrole. Sie geben der strahlungsempfindlichen Schicht mechanische Festigkeit und Resistenz. Mit solchen Gemischen werden Substrate beschichtet, aus denen Kondensatoren, Halbleiter, mehrlagige gedruckte Schaltungen oder integrierte Schaltkreise hergestellt werden können. Speziell sind Siliciumsubstrate zu nennen, die auch thermisch oxidiert und/oder mit Aluminium beschichtet, aber auch dotiert sein können. Es eignen sich auch Metallplatten und -folien, beispielsweise aus Aluminium, Kupfer und Zink, sowie Bi- und Trimetallfolien, aber auch elektrisch nichtleitende Folien, die mit Metallen bedampft sind, und Papier. Diese Substrate können thermisch vorbehandelt, oberflächlich aufgerauht, angeätzt oder, zur Verbesserung erwünschter Eigenschaften, z. B. zur Erhöhung der Hydrophilie, mit Chemikalien vorbehandelt sein. Um der strahlungsempfindlichen Schicht einen besseren Zusammenhalt und/oder eine bessere Haftung auf der Substratoberfläche zu verleihen, kann in ihr ein Haftvermittler enthalten sein. Bei Silicium- bzw. Siliciumdioxid-Substraten kommen hierfür Haftvermittler vom Aminosilan-Typ, wie 3-Aminopropyltriethoxysilan oder Hexamethyldisilazan, in Frage.

Diese Aufzeichnungsmaterialien werden gewöhnlich nach der bildmäßigen Bestrahlung mit wäßrig-alkalischen Lösungen entwickelt, die häufig Tetraalkylammoniumhydroxid als alkalische Komponente enthalten. In der Regel werden wäßrige Lösungen von Tetramethylammoniumhydroxid, (2-Hydroxy-ethyl)-trimethyl-ammoniumhydroxid (= Cholin) oder entsprechende Gemische verwendet (US-A 4 239 661). In der Halbleiterindustrie haben sich solche metallionenfreie Entwickler durchgesetzt, insbesondere in der Produktion von integrierten Schaltkreisen mit hoher Auflösung. Die Kontamination des Halbleitermaterials mit Metallionen würde zu Störungen in der Funktion des Halbleiterbauteils führen.

Die Halbleiterindustrie produziert immer häufiger integrierte Schaltungen mit Strukturen, die deutlich kleiner als 1 µm sind. Durch die gestiegene Integrationsdichte werden die Anforderungen an den photolithographischen Prozeß zur Strukturierung des Photoresists erhöht. Wenn sehr kleine Strukturen, z. B. Kontaktlöcher, abgebildet werden sollen, beobachtet man nach der Entwicklung mit metallionenfreien Entwicklern - selbst bei solchen mit oberflächenaktiven Zusätzen - in den belichteten Bereichen oft eine unvollkommene Entwicklung. Von den Resiststrukturen wird entweder zu wenig oder zu viel weggelöst. Von den auftretenden Entwicklungsfehlern sind Scumming, Micro-grooving und T-Topping die häufigsten.

Als "Scumming" werden Resistrückstände in den Nichtbildbereichen bezeichnet. "Micro-grooving" äußert sich in der Bildung kleiner Aushöhlungen oder Auswaschungen am Fuß der Resiststrukturen und tritt insbesondere bei Hochauflösungsresists auf. Die Ursache für "T-Topping" ist eine schwerlösliche Haut, die nach der Entwicklung zu einem T-Profil der Resistkanten führt.

Diese Fehler können nicht vollständig durch Variationen des Lithographieprozesses überwunden werden, um saubere, fehlerfreie Strukturen im Resist zu erzeugen. Dazu ist meist eine nachträgliche Bearbeitung der strukturierten Resistschicht im Oxidationsplasmareaktor oder durch Sputtern notwendig.

Für die nachfolgenden Ätzprozesse zur Veränderung der Substratoberfläche, dies ist in der Regel für Strukturen mit einer Größe von weniger als 1 µm das Plasmaätzen, führen Scumming oder andere Entwicklungsfehler zu ungleichmäßigen Ätzergebnissen oder - durch notwendiges Überätzen - zu Dimensionsveränderungen der Strukturen.

Insbesondere das T-Topping stört die Inspektion der Linienbreite oder Linienabstände und beeinflußt im nachfolgenden Trockenätzprozeß die maßgetreue Übertragung der Abmessungen der Resiststrukturen ins Substrat.

Die Bildung von Micro-grooves macht sich im Ätzprozeß durch Vergrößerung des Ätzmaßes negativ bemerkbar.

Die EP-A3-0 178 495 beschreibt Entwickler für Photoresists, die aus einer Alkalimetallbase sowie einem fluorierten und einem carboxylierten Tensid bestehen.

US-A-5 286 606 beschreibt ein Verfahren zur Herstellung von Tensiden mit einer geringen Metallionenkonzentration durch ein spezielles Ionenaustauschverfahren.

Mit den bisher verwendeten Tensiden war die wirkungsvolle Unterdrückung der Entwicklungsfehler kaum möglich. Bei hohen Tensidkonzentrationen war ein hoher Dunkelabtrag des Resists an den nicht belichteten Bereichen festzustellen. Dies führte zur Ausbildung flacher Resistprofile und zum Verlust an Auflösung.

Aufgabe der vorliegenden Erfindung ist es daher, einen wäßrigen Entwickler für positiv arbeitende Photoresistzusammensetzungen bereitzustellen, mit dem die oben beschriebenen Probleme überwunden werden können. Bei Verwendung dieses Entwicklers sollen insbesondere Scumming, Micro-grooving und/oder T-Topping nicht mehr auftreten.

Gelöst wird die Aufgabe durch einen metallionenfreien Entwickler, der neben mindestens einem der üblichen basischen Verbindungen noch bestimmte anionische und gegebenenfalls nichtionische Tenside enthält.

Gegenstand der Erfindung ist somit ein metallionenfreier Entwickler, der a) Wasser und b) mindestens eine wasserlösliche, organische, basische Verbindung enthält, und dadurch gekennzeichnet ist, daß er zusätzlich
c) mindestens ein anionisches Tensid der Formel

   R¹-[O-CH₂-CH₂-]_{z}-O-CH₂-COOH (I)

   oder

   R¹-[O-CH₂-CH₂-]_{z}-O-CH₂-SO₃H (II),

   worin

   - R¹: ein (C₁-C₂₀)Alkylrest oder ein gegebenenfalls mit bis zu 3 verzweigten oder geradkettigen Alkylgruppen substituierter (C₆-C₂₀)Arylrest und
   - z: eine ganze Zahl von 1 bis 60 ist, enthält;
   sowie:
d) mindestens ein nichtionisches Tensid der Formel

   CₘH₂ₘ₊₁-[O-CH₂-CH₂-]ₓ[O-CH(CH₃)-CH₂-]_{y}OH (III)

   oder

   CₘH₂ₘ₊₁-[O-CH₂-CH₂-]ₓ[O-CH(CH₃)-CH₂-]_{y}O-CₙH₂ₙ₊₁ (IV),

   wobei
   - m: eine Zahl von 10 bis 22,
   - n: eine Zahl von 1 bis 6 ist und
   - x und y: unabhängig voneinander eine Zahl von 3 bis 30 sind,
   und/oder
e) mindestens ein Tensid der Formel

   HC≡C-CR²R³-[O-CH₂-CH₂-]ᵣOH (V)

   oder

   HO-[CH₂-CH₂-O-]ᵣ-CR⁴R⁵-C≡C-CR²R³-[O-CH₂-CH₂-]ᵣOH (VI),

   worin
   - R²-R⁵: unabhängig voneinander Wasserstoffatome oder (C₁-C₅)Alkylgruppen bedeuten und
   - r: eine Zahl von 1 bis 60 ist;
   oder der Formel

   HO-[CH₂-CH₂-O-]ₛ[CH(CH₃)-CH₂-O-]ₜH (VII),

   worin das Verhältnis s : t von 10 : 90 bis 80 : 20 beträgt;
   oder der Formel

   R⁶-[O-CH₂-CH₂-]ₒ-OH (VIII)

   worin
   - R⁶: ein gegebenenfalls mit bis zu 3 verzweigten oder geradkettigen Alkylgruppen substituierter (C₆-C₂₀)Arylrest und
   - o: eine Zahl von 1 bis 60 ist,
   enthält, wobei der Anteil der anionischen und nichtionischen Tenside 10 ppm bis 6.000 ppm, bezogen auf das Gesamtgewicht des Entwicklers, beträgt, mit der Maßgabe, daß das Gewichtsverhältnis (c) : [(d) + (e)] 3 : 7 bis 8 : 2 beträgt und der Anteil der Tenside (c) stets größer ist als der Anteil der Tenside (d).

Der Rest CₘH₂ₘ₊₁ in den Verbindungen der Formel III und IV ist allgemein ein nicht verzweigter, längerkettiger Alkylrest.

Der erfindungsgemäße Entwickler weist allgemein einen pH-Wert im Bereich von 11 bis 13,5 auf.

Bevorzugte wasserlösliche, organische, basische Verbindungen (b) sind aliphatische oder aromatische Amine, wie Propan-1,3-diamin oder 4,4'-Diamino-diphenylamin, und basische, heterocyclische Verbindungen, die neben 3 bis 5 Kohlenstoffatomen mindestens ein Stickstoffatom sowie gegebenenfalls noch Sauerstoff- oder Schwefelatome im Ring enthalten, wie Pyrazole, Pyrrolidine, Pyrrolidinone, Pyridine, Morpholine, Pyrazine, Piperidine, Oxazole und Thiazole. Ebenfalls bevorzugt sind quaternäre Ammoniumverbindungen, insbesondere gegebenenfalls substituierte Tetraalkylammoniumverbindungen, in denen die Alkylgruppen nicht mehr als jeweils 4 Kohlenstoffatome aufweisen. Besonders bevorzugte Verbindungen dieser Art sind Tetramethylammoniumhydroxid und (2-Hydroxy-ethyl)-trimethylammoniumhydroxid (= Cholin). In dem erfindungsgemäßen Entwickler können auch Gemische verschiedener Basen vorkommen. Der Anteil der Verbindungen (b) beträgt allgemein 0,5 bis 20 Gew.-%, bezogen auf das Gesamtgewicht des Entwicklers.

Bevorzugte anionische Tenside (c) sind O-Carboxymethyl-O'-isononylphenyl-polyethylenglykole, insbesondere solche mit 6 bis 30 Ethylenoxid-Einheiten in der Polyethylenglykolkette (Formel I, z = 6 bis 30, R¹ = (H₃C)₂CH-[CH₂]₆-C₆H₄-).

Von den nichtionische Tenside (d) der Formeln III und IV sind solche bevorzugt, in denen m = 12 bis 18 und n = 2 bis 4, x = 2-8 und y = 3 - 8 sind.

Die gegebenfalls vorhandenen Tenside (e) dienen zur Einstellung der Entwicklungsgeschwindigkeit. Dabei ist r vorzugsweise 3 bis 40.

"Metallionenfrei" bedeutet, daß der erfindungsgemäße Entwickler nicht mehr als 1 ppb an Metallionen enthält.

Der erfindungsgemäße Entwickler wird üblicherweise als Konzentrat hergestellt, das die oben angegebenen Bestandteile (b) bis (e) in doppelter bis achtfacher Menge enthält. Dieses erfindungsgemäße Konzentrat ist stabil, d. h. es tritt keine Phasentrennung, Ausfällung oder Trübung auf. Es kann ohne Schwierigkeiten wieder mit deionisiertem Wasser zu einem gebrauchsfertigen, ebenso stabilen Entwickler mit optimalen Eigenschaften verdünnt werden. Scumming, Micro-grooving und T-Topping werden mit dem erfindungsgemäßen Entwickler wirkungsvoll verhindert, Auflösung und Prozeßbreite entschieden verbessert.

### Beispiele 1 bis 8 und Vergleichsbeispiele V1 bis V2

Zunächst wurden wäßrige Lösungen hergestellt, die 2,38 Gew.-% Tetramethylammoniumhydroxid oder 4,20 Gew.-% Cholin enthielten. Die Lösungen hatten einen pH-Wert von 13. Dann wurden die Tenside (c), (d) und gegebenenfalls (e) in den Mengen gemäß Tabelle zugegeben, um die erfindungsgemäßen Entwicklerlösungen zu erhalten.

Zum Vergleichen wurde ein Entwickler mit 2,38 Gew.-% TMAH und 2000 ppm Dinonylphenolethoxylat, 18 EO Gruppen, (50% Dinonylanteil) gewählt.

Folgender Lithographieprozeß wurde durchgeführt:
Ein Siliciumwafer mit einem Durchmesser von 3 Zoll wurde auf einem Spincoater mit einem Photoresist gemäß EP-A 0 508 267 beschichtet. Nach dem anschließenden Ausheizprozeß (prebake) bei 100 °C für 120 s auf einer Heizplatte (hotplate) betrug die Dicke der Resistschicht 1,1 µm. Der beschichtete Wafer wurde bildmäßig durch eine Maske mit einem Gerät für verkleinernde Projektion (Stepper FPA 1550, g-line, 0,35 NA, 400 mW/cm², Canon Ltd.) UV-bestrahlt. Nach der Belichtung erfolgte ein zweiter Backprozeß (post-exposure-bake) bei 120 °C für 80 s auf einer hotplate.

Entwickelt wurden die Wafer mit den in der Tabelle beschriebenen Entwicklerlösungen auf einem Tracksystem im Puddle Mode für 50 s. Nach Beendigung der Entwicklung wurden die Wafer mit deionisiertem Wasser gespült und trockengeschleudert.

In der folgenden Tabelle bedeuten
A) der Resistabtrag in den unbestrahlten Bereichen;
B) die Bestrahlungsdauer (in Millisekunden) für die 1:1-Abbildung der Maskenstrukturen in den Photoresists (die Strahlungsenergie pro Flächeneinheit [= Bestrahlung] ist gleich der Bestrahlungsdauer multipliziert mit der Bestrahlungsstärke [im vorliegenden Fall 400 mW/cm²]);
C) die Bestrahlungsdauer für den Aufpunkt;
D) das Verhältnis von (B) zu (C) als Maß für die Prozeßbreite des Systems Resist/Entwickler.

Die entwickelten Strukturen wurden mit Hilfe eines Rasterelektronenmikroskops wie folgt bewertet:
- + +: sehr saubere Strukturen mit sehr steilen Resistflanken,
- +: saubere Strukturen mit steilen Resistflanken,
- -: leichte Resistreste (Scum),
- --: deutliches Scumming und T-Topping.

**Tabelle**

| Beispiel Nr. | Tenside | | | Konzentration ppm | Beurteilungskriterien | | | | Strukturqualität |
|---|---|---|---|---|---|---|---|---|---|
| | anionisch * | nichtion. **/**** | Additiv *** | | A nm/50s | B ms | C ms | D | |
| 1 | 100 % | - | - | 1.000 | 12 | 340 | 215 | 1,58 | + |
| 2 | 100 % | - | - | 2.000 | 15 | 340 | 225 | 1,51 | + |
| 3 | 100 % | - | - | 4.000 | 15 | 270 | 180 | 1,50 | + |
| V1 | 40 % | 60 % | - | 3.000 | 10 | 300 | 180 | 1,67 | - |
| 4 | 66,7% | 33,3 % | - | 3.000 | 10 | 340 | 220 | 1,55 | ++ |
| 5 | 75 % | 12,5 % | 12,5 % | 4.000 | 16 | 280 | 200 | 1,40 | ++ |
| 6 | 60 % | 20 % | 20 % | 5.000 | 19 | 280 | 200 | 1,40 | ++ |
| 7 | 40 % | 40 % | 20 % | 5.000 | 18 | 270 | 180 | 1,50 | ++ |
| 8 | 33,3% | 33,3 % | 33,3 % | 2.000 | 14 | 250 | 160 | 1,56 | ++ |
| V2 | - | 100%**** | - | 2.000 | 42 | 320 | 180 | 1,80 | -- |

| | | | | | | | | | |
|---|---|---|---|---|---|---|---|---|---|
| Tensid* Polyoxyethylen-iso-nonylphenylethercarbonsäure 6 Ethylenoxideinheiten (EO) | | | | | | | | | |
| Tensid** Fettalkoholalkoxylat R-(EO)_{3,5}-(PyO)_{5,3}-OH R = H₃C-(CH₂)₁₆-PyO = Propylenoxideinheiten | | | | | | | | | |
| Additiv*** Polyoxyethylen-iso-nonylphenylether, 30 EO | | | | | | | | | |
| Tensid**** Dinonylphenolethoxylat, 18 EO | | | | | | | | | |

## Patentansprüche

1. Metallionenfreier Entwickler, der a) Wasser und b) mindestens eine wasserlösliche, organische, basische Verbindung enthält, und dadurch gekennzeichnet ist, daß er zusätzlich
c) mindestens ein anionisches Tensid der Formel
R¹-[O-CH₂-CH₂-]_{z}-O-CH₂COOH (I)
oder
R¹-[O-CH₂-CH₂-]_{z}-O-CH₂-SO₃H (II),
worin
R¹ ein (C₁-C₂₀)Alkylrest oder ein gegebenenfalls mit bis zu 3 verzweigten oder geradkettigen Alkylgruppen substituierter (C₆-C₂₀)Arylrest und
z eine ganze Zahl von 1 bis 60 ist, enthält;
sowie:
d) mindestens ein nichtionisches Tensid der Formel
CₘH₂ₘ₊₁-[O-CH₂-CH₂-]ₓ[O-CH(CH₃)-CH₂-]_{y}OH (III)
oder
CₘH₂ₘ₊₁-[O-CH₂-CH₂-]ₓ[O-CH(CH₃)-CH₂-]_{y}O-CₙH₂ₙ₊₁ (IV),
wobei
m eine Zahl von 10 bis 22,
n eine Zahl von 1 bis 6 ist und
x und y unabhängig voneinander eine Zahl von 3 bis 30
sind, und/oder
e) mindestens ein Tensid der Formel
HC≡C-CR²R³-[O-CH₂-CH₂-]ᵣOH (V)
oder
HO-[CH₂-CH₂-O-]ᵣ-CR⁴R⁵-C≡C-CR²R³-[O-CH₂-CH₂-]ᵣOH (VI),
worin
R²-R⁵ unabhängig voneinander Wasserstoffatome oder (C₁-C₅)Alkylgruppen bedeuten und
r eine Zahl von 1 bis 60 ist;
oder der Formel
HO-[CH₂-CH₂-O-]ₛ[CH(CH₃)-CH₂-O-]ₜH (VII),
worin das Verhältnis s : t von 10 : 90 bis 80:20 beträgt; oder der Formel
R⁶-[O-CH₂-CH₂-]ₒ-OH (VIII)
worin
R⁶ ein gegebenenfalls mit bis zu 3 verzweigten oder geradkettigen Alkylgruppen substituierter (C₆-C₂₀)Arylrest und
o eine Zahl von 1 bis 60 ist,
enthält, wobei der Anteil der anionischen und nichtionischen Tenside 10 ppm bis 6.000 ppm, bezogen auf das Gesamtgewicht des Entwicklers, beträgt, mit der Maßgabe, daß das Gewichtsverhältnis (c) : [(d) + (e)] 3 : 7 bis 8 : 2 beträgt und der Anteil der Tenside (c) stets größer ist als der Anteil der Tenside (d).

2. Entwickler gemäß Anspruch 1, dadurch gekennzeichnet, daß er einen pH-Wert im Bereich von 11 bis 13,5 aufweist.

3. Entwickler gemäß Anspruch 1 oder 2, dadurch gekennzeichnet, daß die wasserlösliche, organische, basische Verbindung (b) ein aliphatisches oder aromatisches Amin, insbesondere Propan-1,3-diamin oder 4,4'-Diamino-diphenylamin, eine basische, eine heterocyclische Verbindung, die neben 3 bis 5 Kohlenstoffatomen mindestens ein Stickstoffatom sowie gegebenenfalls noch Sauerstoff- oder Schwefelatome im Ring enthält, insbesondere ein Pyrazol, Pyrrolidin, Pyrrolidinon, Pyridin, Morpholin, Pyrazin, Piperidin, Oxazol oder Thiazole, ist.

4. Entwickler gemäß einem oder mehreren der Ansprüche 1 bis 3, dadurch gekennzeichnet, daß wasserlösliche, organische, basische Verbindung (b) Tetramethylammoniumhydroxid oder (2-Hydroxyethyl)-trimethyl-ammoniumhydroxid ist.

5. Entwickler gemäß einem oder mehreren der Ansprüche 1 bis 4, dadurch gekennzeichnet, daß der Anteil der wasserlöslichen, organischen, basischen Verbindung (b) 0,5 bis 20 Gew.-% beträgt, bezogen auf das Gesamtgewicht des Entwicklers.

6. Entwicklerkonzentrat, dadurch gekennzeichnet, daß es die Bestandteile (b) bis (e) gemäß einem oder mehreren der Ansprüche 1 bis 5 in doppelter bis achtfacher Menge enthält.

## Claims

1. A metal-ion-free developer containing a) water and b) at least one water-soluble organic basic compound, which developer additionally comprises
c) at least one anionic surfactant of the formula
R¹-[O-CH₂-CH₂-]_{z}-O-CH₂-COOH (I)
or
R¹-[O-CH₂-CH₂-]_{z}-O-CH₂-SO₃H (II),
where
R¹ is a (C₁-C₂₀) alkyl radical or a (C₆-C₂₀)aryl radical optionally substituted with up to 3 branched or straight-chain alkyl groups, and
z is an integer from 1 to 60;
and also comprises:
d) at least one nonionic surfactant of the formula
CₘH₂ₘ₊₁-[O-CH₂CH₂-]ₓ[O-CH(CH₃)-CH₂-]_{y}OH (III)
or
CₘH₂ₘ₊₁-[O-CH₂CH₂-]ₓ[O-CH (CH₃) -CH₂-]_{y}O-CₙH₂ₙ₊₁ (IV),
where
m is a number from 10 to 22,
n is a number from 1 to 6, and
x and y are, independently of one another, a number from 3 to 30,
and/or
e) at least one surfactant of the formula
HC≡C-CR²R³-[O-CH₂-CH₂-]ᵣOH (V)
or
HO-[CH₂-CH₂-O-]ᵣ-CR⁴R⁵-C≡C-CR²R³-[O-CH₂-CH₂-]ᵣOH (VI),
where
R² - R⁵ are, independently of one another, hydrogen atoms or (C₁-C₅)alkyl groups and
r is a number from 1 to 60;
or of the formula
HO-[CH₂-CH₂-O-]ₛ[CH (CH₃)-CH₂-O-]ₜH (VII),
where the ratio s : t is from 10 : 90 to 80 : 20;
or of the formula
R⁶-[O-CH₂-CH₂-]₀-OH (VIII)
where
R⁶ is a (C₆-C₂₀)aryl radical optionally substituted with up to 3 branched or straight-chain alkyl groups, and
o is a number from 1 to 60,
the proportion of the anionic and nonionic surfactants being from 10 ppm to 6,000 ppm, based on the total weight of the developer, with the proviso that the weight ratio (c) : [(d) + (e)] is from 3 : 7 to 8 : 2 and the proportion of the surfactants (c) is always greater than the proportion of the surfactants (d).

2. A developer as claimed in claim 1, which has a pH in the range from 11 to 13.5.

3. A developer as claimed in claim 1 or 2, wherein the water-soluble organic basic compound (b) is an aliphatic or aromatic amine, in particular propane-1,3-diamine or 4,4'-diaminodiphenylamine, a basic heterocyclic compound which contains, in addition to 3 to 5 carbon atoms, at least one nitrogen atom and, optionally, also oxygen or sulfur atoms in the ring, in particular a pyrazole, pyrrolidine, pyrrolidinone, pyridine, morpholine, pyrazine, piperidine, oxazole or thiazoles.

4. A developer as claimed in one or more of claims 1 to 3, wherein the water-soluble organic basic compound (b) is tetramethylammonium hydroxide or (2-hydroxyethyl)trimethylammonium hydroxide.

5. A developer as claimed in one or more of claims 1 to 4, wherein the proportion of the water-soluble organic basic compound (b) is from 0.5 to 20% by weight, based on the total weight of the developer.

6. A developer concentrate, which contains the constituents (b) to (e) as claimed in one or more of claims 1 to 5 in two to eight times the amount.

## Revendications

1. Révélateur dépourvu d'ions métalliques qui contient a) de l'eau et b) au moins un composé basique, organique, hydrosoluble, et est caractérisé en ce qu'il contient en outre
c) au moins un agent tensio-actif anionique de formule
R¹-[O-CH₂-CH₂-]_{z}-O-CH₂-COOH (I)
ou
R¹-[O-CH₂-CH₂-]_{z}-O-CH₂-SO₃H (II),
où
R¹ est un reste alkyle en C₁ à C₂₀ ou un reste aryle en C₆ à C₂₀, éventuellement substitué par jusqu'à 3 groupes alkyle ramifiés ou rectilignes et
z est un nombre entier de 1 à 60 ;
ainsi que
d) au moins un agent tensio-actif non ionique de formule
CₘH₂ₘ₊₁-[O-CH₂-CH₂-]ₓ[O-CH(CH₃)-CH₂-]_{y}OH (III)
ou
CₘH₂ₘ₊₁-[O-CH₂-CH₂-]ₓ[O-CH(CH₃)-CH₂-]_{y}O-CₙH₂ₙ₊₁ (IV),
m étant un nombre de 10 à 22,
n étant un nombre de 1 à 6 et
x et y étant, indépendamment l'un de l'autre, un nombre de 3 à 30,
et/ou
e) au moins un agent tensio-actif de formule
HC≡C-CR²R³-[O-CH₂CH₂-]ᵣOH (V)
ou
HO-[CH₂-CH₂-O-]ᵣ-CR⁴R⁵-C≡C-CR²R³-[O-CH₂-CH₂-]ᵣOH (VI),
où
R² à R⁵ représentent, indépendamment les uns des autres, des atomes d'hydrogène ou des groupes alkyle en C₁ à C₅ et
r est un nombre de 1 à 60 ;
ou de formule
HO-[CH₂-CH₂-O-]ₛ[CH(CH₃)-CH₂-O-]ₜH (VII),
dans laquelle le rapport s : t est de 10 : 90 à 80 : 20 ; ou de formule
R⁶-[O-CH₂-CH₂-]ₒ-OH (VIII)
dans laquelle
R⁶ est un reste aryle en C₆ à C₂₀, éventuellement substitué par jusqu'à 3 groupes alkyle ramifiés ou rectilignes et
o est un nombre de 1 à 60 ;
la part des agents tensio-actifs anioniques et non ioniques représentant 10 ppm à 6000 ppm, par rapport au poids total du révélateur, sous réserve que la proportion en poids (c) : [(d) + (e)] soit de 3 : 7 à 8 : 2 et que la portion des agents tensio-actifs (c) soit toujours supérieure à la portion des agents tensio-actifs (d).

2. Révélateur selon la revendication 1, caractérisé en ce qu'il présente un pH dans le domaine de 11 à 13,5.

3. Révélateur selon la revendication 1 ou 2, caractérisé en ce que le composé basique, organique, hydrosoluble (b) est une amine aliphatique ou aromatique, en particulier la propane-1,3-diamine ou la 4,4-diaminodiphénylamine, un composé hétérocyclique basique qui contient dans le cycle, outre 3 à 5 atomes de carbone, au moins un atome d'azote ainsi qu'éventuellement en plus des atomes d'oxygène ou de soufre, en particulier un pyrazole, une pyrrolidine, une pyrrolidinone, une pyridine, une morpholine, une pyrazine, une pipéridine, un oxazole ou des thiazoles.

4. Révélateur selon une ou plusieurs des revendications 1 à 3, caractérisé en ce que le composé basique, organique, hydrosoluble (b) est l'hydroxyde de tétraméthylammonium ou l'hydroxyde de (2-hydroxyéthyl)-triméthylammonium.

5. Révélateur selon une ou plusieurs des revendications 1 à 4, caractérisé en ce que la part du composé basique, organique, hydrosoluble (b) est de 0,5 à 20% en poids, par rapport au poids total du révélateur.

6. Concentré de révélateur, caractérisé en ce qu'il contient les constituants (b) à (e) selon une ou plusieurs des revendications 1 à 5 en des quantités doubles à huit fois supérieures.
